Europäisches Patentamt

European Patent Office

Office européen des brevets

(11) Publication number: **0 257 783**
**A1**

(12) **EUROPEAN PATENT APPLICATION**

(21) Application number: 87306434.9

(22) Date of filing: 21.07.87

(51) Int. Cl.⁴: **C23C 14/54**

(30) Priority: 22.08.86 US 898983

(43) Date of publication of application:
02.03.88 Bulletin 88/09

(84) Designated Contracting States:
**AT CH DE FR GB IT LI SE**

(71) Applicant: **BORG-WARNER CORPORATION**
**200 South Michigan Avenue**
**Chicago Illinois 60604(US)**

(72) Inventor: **Sproul, William Dallas**
**500 South Bristol Court**
**Palatine Illinois 60067(US)**
Inventor: **Tomashek, James Raymond**
**114 East Division Street**
**Wood Dale Illinois 60191(US)**

(74) Representative: **Williams, Trevor John et al**
**J.A. KEMP & CO. 14 South Square Gray's Inn**
**London WC1R 5EU(GB)**

(54) **Control system and method for controlling the reactive sputtering of a metallic compound.**

(57) A metal, such as titanium, from group IVb of the periodic table is used as the target in a reactive deposition process. Ionized inert gas (16) (for example, argon) bombards the target in a sealed sputtering chamber (15) to initiate sputtering of the target metal. Reactive gas (19), such as nitrogen, is admitted into the chamber to mix with the inert gas and combine with the metal atoms, that are dislodged from the target in response to the ion bombardment, to produce a metallic compound (titanium nitride) on a substrate. The amount of the reactive gas in the chamber (15) is closely regulated and held at a desired reference setpoint by a control loop (19-24) to maximize the rate of deposition of the metallic compound onto the substrate. In addition, the setpoint (42) is automatically controlled (44-48) in response to the amount of hydrogen in the sputtering chamber (15) (which hydrogen is proportional to the water vapor) in order to maintain the quality of the coating on the substrate, particularly the color and composition of the coating, despite the presence of undesired water vapor in the chamber.

# CONTROL SYSTEM AND METHOD FOR CONTROLLING THE REACTIVE SPUTTERING OF A METALLIC COMPOUND

## Description

This invention relates to the reactive sputtering of titanium and like metallic nitrides onto a substrate or workpiece in a vacuum sputtering chamber, and is particularly addressed to a control system for automatically regulating a reactive sputtering process to effectively preclude the deleterious effects otherwise occurring when undesired water vapor is present in the sputtering chamber during the process, thereby ensuring the quality of the deposited coating.

Cathode sputtering or radio-frequency ionic sputtering involves a vacuum sputtering chamber having a target, of the material to form the coating, in a gas discharge wherein the target material is sputtered by ion bombardment, the particles removed from the target being deposited on the substrate. The target becomes the cathode and an anode is located beyond the cathode in the vacuum chamber. Atoms are ejected from the target and condense on surfaces, such as the substrate, which are close to the target. Where a thin film of metallic compounds, such as the oxides, nitrides, carbides and the like, are to be deposited on various substrates, reactive sputtering can be used, the target consisting of the material for the coating. A neutral gas, such as argon, is mixed with a reactive gas such as oxygen, nitrogen or methane. The particles that are dislodged from the target during the bombardment combine with the reactive gas to produce the desired metallic compound which is deposited on the substrate or workpiece.

In a prior rapid rate reactive sputtering system, which is described in United State Patent 4,428,811, issued January 31, 1984, and assigned to the present assignee, the flow of reactive gas (shown as nitrogen) into the sputtering chamber is precisely controlled and held at a desired reference setpoint to maximize the rate of deposition of the desired film onto a substrate. This is achieved by means of a nitrogen control loop which senses the partial pressure of the nitrogen (which pressure represents the amount of nitrogen in the sputtering chamber) and regulates the flow of that gas into the chamber as required to hold the partial pressure constant, thereby to maintain the nitrogen at the desired reference setpoint. By automatically maintaining the reactive gas in the sputtering chamber at the correct setpoint level, a nitride deposition rate is achieved which is essentially 100% of the deposition rate of the pure metal. With the arrangement of the aforementioned U.S. patent, the composition of the coating will be constant and will be at or very close to the stoichiometric value. The high deposition rate of the metallic compound and the control of stoichiometry works for the reactive sputtering of all of the group IVb elements of the periodic table in an inert gas/reactive gas controlled environment. Thus, high rate deposition and controlled stoichiometry are obtained with the reactive sputtering of titanium nitride, zirconium nitride and hafnium nitride.

The rapid rate reactive sputtering process, described in the U. S. patent, is very stable and reproducible as long as the vacuum sputtering chamber is clean and free of water vapor. Under those conditions the coating composition can be optimized as desired. For example, if the coating is titanium nitride it may be given a composition resulting in a gold-like appearance very close to gold. Unfortunately, when the chamber is opened for target change and cleaning, the chamber walls and fixturing absorb water vapor from the atmosphere, and this water vapor comes off very slowly when the chamber is subsequently closed up and pumped to high vacuum. When reactive sputtering occurs in a chamber that has recently been opened, heat from the sputtering process helps release the retained water vapor. The water vapor, when released into the plasma, breaks down into hydrogen and oxygen, and the oxygen combines with the metal preferentially over the nitrogen. Even though the amount of nitrogen in the sputtering chamber is maintained at a constant setpoint level (by holding the partial pressure of the nitrogen at a constant value) by a nitrogen control loop, the nitrogen flow is actually decreased because oxygen is taking its place. The coating therefore becomes nitrogen deficient with the result that its color changes to a light gold and its properties and composition change. Eventually with time the problem disappears because the water vapor is driven off and consumed, but until it is removed the water vapor deleteriously affects the operation of the sputtering system.

This shortcoming has now been overcome by the present invention which effectively renders the sputtering process immune to the presence of undesired water vapor in the sputtering chamber. This is achieved by varying the nitrogen partial pressure in response to the water vapor.

The invention provides a control system for regulating the reactive deposition of a metallic compound onto a substrate in a sealed sputtering chamber; where an inert gas (such as argon), admitted into the chamber, ionizes and bombards a target, of the material to be deposited, to initiate sputtering of the target material; where a reactive gas (such as nitrogen), also admitted into the chamber, reacts with the sputtered target material; and where the flow of the incoming reactive gas is regulated by a control loop to maintain the amount of that gas in the chamber at a desired reference setpoint to maximize the rate of deposition. The control system comprises setpoint controlling means for automatically controlling the setpoint of the reactive gas (nitrogen) in response to undesired water vapor in the chamber to ensure the quality of the metallic compound coated on the substrate. The setpoint controlling means is specifically operated in response to the partial pressure of the hydrogen in the chamber released from the water vapor. The hydrogen is not consumed in the reactive process, and its partial pressure rises in proportion to the amount of water vapor being released. The hydrogen partial pressure in the chamber is measured and when a pressure increase is sensed the nitrogen partial pressure is automatically increased by increasing the nitrogen setpoint in the control loop.

In accordance with another aspect of the invention, a unique method is provided for controlling the reactive sputtering process, the method comprising the steps of establishing a flow of reactive gas into the sputtering chamber, during normal operating conditions when a normal acceptable amount of water vapor is present in the chamber, at a reference setpoint appropriately selected to obtain a maximum rate of deposition on the substrate; effectively monitoring the water vapor in the chamber and varying the setpoint in response to water vapor changes; and varying the reactive gas flow in accordance with the modified setpoint to compensate for the changes in water vapor in the sputtering chamber to ensure the quality of the deposition.

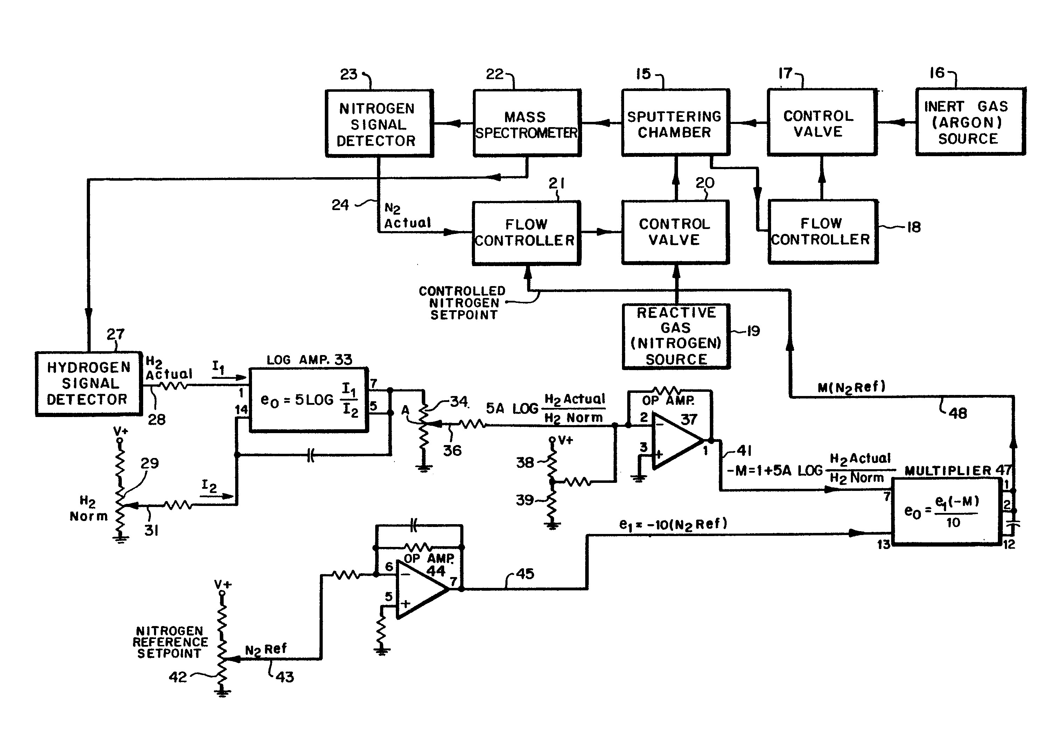

The features of the invention which are believed to be novel are set forth with particularity in the appended claims. The invention may best be understood, however, by reference to the following description in conjunction with the accompanying drawing which schematically illustrates a reactive sputtering apparatus having a control system constructed in accordance with the invention.

Referring to the drawing, block 15 - 24 depict the reactive sputtering apparatus of the aforementioned U.S. Patent, the teachings of which are incorporated herein by reference. Of course, the sputtering apparatus is disclosed in much greater detail in the patent and attention is directed thereto for a detailed explanation. The sputtering system is capable of depositing a thin film of titanium nitride, or other similar compounds of the group IVb metals of the periodic table, in the form of oxides, nitrides or carbides on a suitable substrate. At this time the group IVb metals are titanium, zirconium and hafnium. As explained in the U. S. Patent, a substrate to be coated is positioned within a sealed sputtering chamber 15 from which air and other contaminants are continuously being drawn out by means of a vacuum system. Initially, the substrate is moved to one end of the chamber for etching. There, a potential is applied to the substrate and an inert gas (specifically argon) from source 16, which gas is admitted to the chamber by valve 17 under control of flow controller 18, ionizes to provide argon ions which bombard the substrate to clean the surface to be coated.

Once cleaned, the potential is removed and the substrate is repositioned within the chamber 15 to be beneath a target formed of the metal (namely, titanium) to be sputtered, a cathode being above and in contact with the target. A controlled flow of a reactive gas (specifically nitrogen) from source 19 is received by chamber 15 via control valve 20 which is regulated by flow controller 21. An appropriate potential is applied to the cathode to ionize the argon gas, whereupon the argon ions bombard the titanium target to initiate sputtering and to dislodge titanium atoms. With the substrate established at the required bias potential, titanium atoms react with the nitrogen gas to form titanium nitride on the cleaned substrate. Flow controller 18, whose input signal represents the total pressure of the gases inside of chamber 15, is adjusted to regulate the operation of control valve 17 to maintain that total pressure at a desired constant level. Admission of the nitrogen gas is controlled by operation of the control valve 20 which in turn is governed by the flow controller 21. Mass spectrometer 22 effectively measures or senses the partial pressure of each of the gases found in the sputtering chamber 15, providing a series of time-spaced peaks each of which represents the partial pressure of an assigned gas in the chamber. Nitrogen signal detector 23 responds to, or "looks" at, only the sensed nitrogen partial pressure to produce a signal proportional to and representing the amount of nitrogen in the chamber. This signal is found on line 24 and is labeled "$N_2$ Actual" in the drawing, meaning that the signal represents the actual nitrogen in the chamber at the time. As taught in the aforementioned patent, a rate of deposition of titanium nitride that is almost 100% of the deposition rate of the pure metal is achieved by closely controlling the nitrogen flow to hold the amount of nitrogen in the chamber at a desired reference setpoint. This is accomplished by the control loop comprising elements 19 - 24. The desired setpoint is established by manually adjusting a potentiometer, within or associated with flow controller 21, in the cited patent. The actual nitrogen signal on line 24 is effectively compared with a setpoint signal from the potentiometer and the difference between those signals governs the operation of control valve 20 to automatically regulate the nitrogen flow so as to maintain the amount of nitrogen in the chamber at the desired setpoint level.

It will be appreciated that since all of the elements 15 - 24 are illustrated and described in substantial detail in the previously cited U. S. patent, detailed disclosure of those elements have not been included to avoid unduly encumbering the present patent application. Turning now to the invention, the reactive sputtering process is additionally controlled to automatically compensate for water vapor in the sputtering chamber so that pure titanium nitride, having the desired gold-like appearance and the correct composition, will be deposited on the substrate. In short, this is accomplished by automatically adjusting the setpoint of flow controller 21 when water vapor is present in the sputtering chamber, the setpoint being varied in direct proportion to changes in water vapor. More specifically, the hydrogen in the sputtering chamber is proportional to the water vapor so the hydrogen partial pressure or peak, measured by mass spectrometer 22, is utilized by the hydrogen signal detector 27 to provide on line 28 a signal representing the amount of hydrogen, and thus the amount of water vapor, in the chamber. As indicated by the label "$H_2$ Actual", associated with line 28, this signal represents the actual hydrogen in the chamber. Potentiometer 29, on the other hand, is adjusted to produce on line 31 a signal representing the amount of hydrogen which is present during normal operating conditions.

To explain, preferably the hydrogen signal is not compared to an absolute value all of the time. Instead, the hydrogen level is compared with a reference point representing the normal amount of hydrogen that would exist after the system is warmed up and a run is about to be started. The hydrogen setpoint, provided by potentiometer 29, provides a starting point or background level indicating the usual amount of hydrogen (which will be acceptable) for the condition of the chamber at the time a run is started. Of course, the function of potentiometer 29 could be automated. After the system is warmed up and before a run is begun the actual hydrogen level could be read and stored in a memory, and then used as the reference point for the entire run. For simplicity, the hydrogen setting is adjusted manually by the operator in the illustrated embodiment.

Log amplifier 33 is an integrated circuit, such as a type BB LOG-100, made by Burr Brown, which receives on its pin 1 a current signal $I_1$ representing the actual hydrogen in the chamber, and on its pin 14 a current signal $I_2$ representing

the normal acceptable amount of hydrogen. The log amplifier performs the indicated function or computation so that the output voltage $e_0$ appearing between pins 5, 7 and the ground reference plane will be 5 LOG

$$\frac{I_1}{I_2}$$

. It is apparent that if the actual hydrogen equals the normal hydrogen level, the output voltage $e_0$ (or difference signal) will be zero since the log of one is zero. Assuming that there is a difference between $I_1$ and $I_2$, the voltage at the adjustable tap of the potentiometer 34, relative to the voltage ($e_0$) across the entire potentiometer, is designated by the letter A. Hence, the voltage signal on line 36 will be a scaled-down version of $e_0$ and will represent the function 5A LOG

$$\frac{H_2 \quad Actual}{H_2 \quad Norm}$$

. Operational amplifier 37 (which may be an integrated circuit type MC 1458CP1 made by Motorola) serves as an analog adder and inverter, pin 2 functioning as a summing point for the signal on line 36 and a fixed amplitude signal; from voltage divider 38, 39. With this arrangement, the indicated output voltage -M will appear on line 41. The voltage M has a negative sign due to the phase inversion imparted by operational amplifier 37.

Potentiometer 42 is adjusted by the operator, in the manner taught in the previously cited U. S. patent to provide a desired nitrogen reference setpoint at which the rate of deposition on the substrate will be maximized. In the cited patent, the signal from potentiometer 42 on line 43, labeled "$N_2$ Ref" provides the nitrogen setpoint for flow controller 21 to automatically maintain a constant accordance with the present invention, that reference setpoint is established to provide a maximum deposition rate during normal operating conditions when the water vapor is at its normal acceptable background level, at which time the two signals applied to log amplifier 33 will be equal. When the water vapor changes, the nitrogen reference setpoint by potentiometer 42 is varied by multiplier 47 so that flow controller 21 will now operate at a new, modified setpoint to effectively compensate for the water vapor change to ensure the quality of the deposition.

To elucidate, operational amplifier 44, which may also be a type MC 1458CP1, inverts the N₂ Ref signal and multiplies it by 10. The output voltage $e_1$ of the amplifier on line 45 will therefore represent the indicated function -10 (N₂ Ref). Multiplier 47, preferably an integrated circuit type BB 4206 made by Burr Brown, multiplies the two signals on lines 41 and 45 and divides the product by 10 to provide on line 48 the output voltage representing the function M (N₂ Ref), this voltage providing the controlled nitrogen setpoint for flow controller 21. Hence, the reference setpoint (N₂ Ref) will be modified by the function M before it is applied to the flow controller. In the event that the actual hydrogen equals the normal hydrogen, the function M will be equal to one and the voltage applied to flow controller 21 over line 48 will be identical to that provided on line 43 by potentiometer 42. In this case, the reactive sputtering system will operate in the same manner as taught in the aforementioned patent and the color and composition of the deposited coating will be as desired. On the other hand, if the water vapor in the chamber rises above or drops below the normal level (at which potentiometer 29 is set), M will have a value different than one, as a result of which the setpoint of the nitrogen is automatically changed from its reference level as necessary to maintain the proper color and composition of the metallic coating, while at the same time maximizing the rate of deposition on the substrate. Specifically, as the water vapor (and hence hydrogen) increases, M increases and produces a higher nitrogen setpoint to increase the nitrogen partial pressure in the sputtering chamber. A water vapor decrease produces the opposite result.

In the described embodiment, the controlled nitrogen setpoint on line 48 changes exponentially as the water vapor and the actual hydrogen change, the nitrogen setpoint initially rising fast even though the hydrogen increases very little. This provides optimum operation. The particular function M by which the reference setpoint N₂ Ref is multiplied in the illustrated embodiment to obtain the actual setpoint was determined empirically for a specific sputtering arrangement. Obviously, the function M may take any appropriate form sufficient to control the setpoint applied to a hydrogen control loop.

While a particular embodiment of the invention has been shown and described, modifications may be made, and it is intended in the appended claims to cover all such modifications as may fall within the true spirit and scope of the invention.

## Claims

1. A control system for regulating the reactive deposition of a metallic compound onto a substrate in a sealed sputtering chamber (15); where an inert gas (16), admitted into the chamber, ionizes and bombards a target of the material to be deposited, to initiate sputtering of the target material; where a reactive gas (19), also admitted into the chamber, reacts with the sputtered target material; and where the flow of the incoming reactive gas is regulated by a control loop (19-24) to maintain the amount of that gas in the chamber at a desired reference setpoint (42) to minimize the rate of deposition, said control system comprising:
setpoint controlling means (44-48) for automatically controlling the setpoint of the reactive gas in response to undesired water vapor in the chamber to ensure the quality of the metallic compound coated on the substrate.

2. A control system according to claim 1 wherein the setpoint (42) of the reactive gas is adjusted in response to the amount of hydrogen present in the chamber.

3. A control system according to claim 1 wherein the setpoint controlling means includes sensing means (22) for sensing the hydrogen in the chamber (15) to determine the amount of water vapor, the setpoint being varied in response to the sensed hydrogen.

4. A control system according to claim 3 wherein the setpoint (42) of the reactive gas is varied directly with the sensed hydrogen.

5. A control system according to claim 3 wherein said sensing means includes a spectrometer (22) which senses the partial pressure of the hydrogen in the chamber.

6. A control system according to claim 1 wherein the reference setpoint (29) is multiplied by a function (33), which effectively represents and is determined by the water vapor in the chamber, to derive the actual setpoint at which the reactive gas flow is maintained.

7. A control system according to claim 1 wherein the actual amount of water vapor in the chamber (15) is effectively compared with a predetermined acceptable amount of water vapor, the setpoint (42) of the reactive gas being modified in response to any difference between the amounts.

8. A control system according to claim 7 wherein the actual hydrogen (28) in the chamber (15) is compared with a normal acceptable amount of hydrogen (29), present in the chamber during normal operating conditions, to produce a difference signal (A) which is then employed to vary the setpoint from its reference level.

9. A control system according to claims 8 wherein the difference signal (A) is employed to produce a signal representing a function which is then multiplied by a signal representing the reference setpoint to produce a signal representing a new, modified setpoint.

10. A control system according to claim 8 wherein the difference signal (A) is produced by a log amplifier (33) and is proportional to the log of the actual hydrogen divided by the normal hydrogen.

11. A control system according to claim 1 wherein the metallic compound is titanium nitride and the reactive gas is nitrogen.

12. A control system for controlling the reactive deposition of a metallic compound onto a substrate in a sputtering chamber (15), using a metal from group IVb of the periodic table; where an ionized inert gas (16) bombards a target, of the material to be deposited, to initiate sputtering in the chamber; where a reactive gas (19) mixes with the inert gas and combines with the atoms that are dislodged from the target in response to the ion bombardment to produce the metallic compound which is coated on the substrate; and where the amount of the reactive gas in the chamber is regulated and held at a desired reference setpoint by a control loop (19-24) to maximize the rate of deposition, said control system comprising:

means (21) for automatically controlling the setpoint of the reactive gas in response to the amount of hydrogen in the chamber in order to maintain the quality of the metallic coating on the substrate despite the presence of undesired water vapor in the chamber.

13. A method of controlling the reactive deposition of a group IVb metallic compound onto a substrate in a sputtering chamber, comprising the steps of:

establishing a flow of reactive gas (19) into the sputtering chamber, during normal operating conditions when a normal acceptable amount of water vapor is present in the chamber, at a reference setpoint (42) appropriately selected to obtain a maximum rate of deposition on the substrate;

effectively monitoring (22) the water vapor in the chamber and varying the setpoint in response to water vapor changes;

and varying the reactive gas flow in accordance with the modified setpoint to compensate for the changes in water vapor in the sputtering chamber to ensure the quality of the deposition.

14. A method of controlling the reactive deposition as set forth in claim 13 wherein the hydrogen in the sputtering chamber is sensed (22) to determine the amount of water vapor present and wherein the setpoint (42) is modified in response to the sensed hydrogen.

0 257 783

| | DOCUMENTS CONSIDERED TO BE RELEVANT | | EP 87306434.9 |
|---|---|---|---|
| **Category** | Citation of document with indication, where appropriate, of relevant passages | Relevant to claim | CLASSIFICATION OF THE APPLICATION (Int. Cl.4) |
| A | US - A - 4 428 811 (W.D. SPROULET et al.) <br><br> * Fig. 1-4; Claims * | 1,13 | C 23 C 14/54 |
| A | EP - A2 - 0 151 737 (SIEMENS AKTIENGESELLSCHAFT) <br><br> * Claims * | 1,13 | |
| A | DD - A1 - 217 825 (DEUTSCHE POST, RUNDFUNK- UND FERNSEHTECHNISCHES ZENTRALAMT) <br><br> * Fig.; claims * | 1,13 | |
| A | PATENT ABSTRACTS OF JAPAN, un-examined applications, C field, vol. 10, no. 98, April 15, 1986 <br> THE PATENT OFFICE JAPANESE GOVERNMENT <br> page 96 C 339 <br><br> * Kokai-no. 60-228673 (HITACHI SEISAKUSHO) * | 1,13 | **TECHNICAL FIELDS SEARCHED (Int. Cl.4)** <br><br> C 23 C |

The present search report has been drawn up for all claims

| Place of search | Date of completion of the search | Examiner |
|---|---|---|
| VIENNA | 16-10-1987 | SLAMA |